# EUROPEAN PATENT APPLICATION

(11) **EP 4 835 178 A1**
(43) Date of publication of application: **04.11.2026**
(21) Application number: 24910563.6
(22) Date of filing: 03.12.2024
(51) Int. Cl.: C30B 29/22, C30B 7/14, H01M 4/525

(54) **METAL OXIDE PRECURSOR, PREPARATION METHOD THEREFOR, AND USE THEREOF**

(30) Priority: 29.12.2023 CN 202311873876
(71) Applicant: HUAYOU NEW ENERGY TECHNOLOGY (QUZHOU) CO., LTD., Quzhou, Zhejiang 324000 (CN); ZHEJIANG HUAYOU COBALT CO., LTD., Jiaxing, Zhejiang 314000 (CN)
(72) Inventor: XU, Wei, Quzhou, Zhejiang 324000 (CN); ZHAO, Haiying, Quzhou, Zhejiang 324000 (CN); LIU, Zeping, Quzhou, Zhejiang 324000 (CN); ZHANG, Yan, Quzhou, Zhejiang 324000 (CN); DONG, Yu, Quzhou, Zhejiang 324000 (CN)
(74) Representative: MERH-IP Matias Erny Reichl Hoffmann Patentanwälte PartG mbB
(86) International application number: PCT/CN2024/136332
(87) International publication number: WO 2025/139631

(57) **Abstract**

A metal oxide precursor, a preparation method therefore, and a use thereof are provided. The metal oxide precursor for preparing a cathode material is a single-crystal structure, and in a cumulative particle size distribution curve function f(x) of the metal oxide precursor, f(x) is a cumulative particle size distribution, 0 < f(x) < 100%, x is a particle size, 0.05 µm < x < 20 µm. When f(x₁)=25%, f(x₂)=75%, n particle size values exist between x₁ and x₂, in which, n is a number of particle size values between x₁ and x₂, and n > 0; an average value of tangent slopes of corresponding point values of x₁, x₂, and the n particle size values in the cumulative particle size distribution curve is K', K' > 25, in which, a tangent slope of a point value is K, and K is a derivative of the cumulative particle size distribution curve function f(x) of the metal oxide precursor. The metal oxide precursor of the present application has a single-crystal structure and excellent uniformity of particle size distribution, high sintering activity, and good uniformity, thereby facilitating the improvement of the discharge capacity and cycle performance of the cathode material.

## Description

The present application claims the priority of the Chinese patent application with application number 202311873876.2 and titled "Metal oxide precursor, preparation method thereof, and application thereof" filed with the Chinese Patent Office on December 29, 2023, the contents of which are incorporated by reference into the present application.

### TECHNICAL FIELD

The present application relates to the technical field of battery technology, more particularly to a metal oxide precursor, a preparation method thereof, and an application thereof.

### BACKGROUND

Currently, the precursors prepared by mainstream co-precipitation methods are typically secondary agglomerated particles, which can only produce polycrystalline cathodes upon sintering. During the charge-discharge process of polycrystalline cathode materials, the insertion and extraction of alkali metal ions cause the expansion and contraction of individual crystals, generating stress at grain boundaries. This results in grain boundary tearing and leads to degraded cycling performance.

The single-crystal structure precursors prepared by the traditional spray method usually have the characteristics of large primary particle size, uneven particle size, and regular octahedral-like structure. However, the single-crystal structure precursors based on these characteristics have the following problems: (1) They are easy to break during compaction; (2) The sintering activity is reduced, resulting in a long sintering time and high energy consumption; (3) Due to the uneven particle size, the sintering is uneven, resulting in poor electrochemical performance of the cathode material.

### SUMMARY

It is one of objectives of embodiments of the present application to provide a metal oxide precursor, a preparation method thereof, and an application thereof, aiming to solve the problem that the single-crystal structure precursor is easy to break during the compaction process, the particle size is uneven, the sintering activity is reduced, and the sintering is uneven.

Technical solutions adopted by the embodiments of the present application are as follows:
In the first aspect, a metal oxide precursor for preparing a cathode material is provided. The metal oxide precursor is a single-crystal structure, and in a cumulative particle size distribution curve function f(x) of the metal oxide precursor, f(x) is a cumulative particle size distribution, 0 < f(x) < 100%, x is a particle size, 0.05 µm < x < 20 µm.

When f(x₁)=25%, f(x₂)=75%, n particle size values exist between x₁ and x₂, in which, n is a number of particle size values between x₁ and x₂, and n > 0; an average value of tangent slopes of corresponding point values of x₁, x₂, and the n particle size values in the cumulative particle size distribution curve is K', K' > 25, in which, a tangent slope of a point value is K, and K is a derivative of the cumulative particle size distribution curve function f(x) of the metal oxide precursor.

In some embodiments, in the cumulative particle size distribution curve of the metal oxide precursor, an X-axis is a logarithmic scale of a particle size x of the metal oxide precursor, marked as log₁₀(x), and a Y-axis is a cumulative volume proportion of the metal oxide precursor corresponding to a particle size condition of the X-axis, marked as f(x).

In some embodiments, the average value K' of the tangent slopes of corresponding point values of x₁, x₂, and the n particle size values in the cumulative particle size distribution curve is calculated as follows: $K ′ = \frac{{K}_{1} + {K}_{2} + \sum {K}_{n}}{n + 2}$, in which, K₁, K₂, and Kₙ are derivatives of cumulative particle size distribution curve functions f(x₁), f(x₂), and f(xₙ) of the metal oxide precursor having particle sizes of x₁, xₙ, and x₂, respectively, and a particle size xₙ is a particle size value between the particle size x₁ and the particle size x₂.

In some embodiments, an angle between a straight line having a slope of K' and an X-axis is θ₁, and 87.7° ≤ θ₁ ≤ 90°.

In some embodiments, an angle between a straight line having a slope of K' and a Y-axis is θ₂, and θ₂/90° < 0.024.

In some embodiments, a D₅₀ of the metal oxide precursor is 0.5 µm to 2.5 µm.

In some embodiments, a Dₘᵢₙ of the metal oxide precursor is 0.05 µm to 0.3 µm.

In some embodiments, a Dₘₐₓ of the metal oxide precursor is 5 µm to 20 µm.

In some embodiments, a specific surface area of the metal oxide precursor is 8 m²/g to15 m²/g.

In some embodiments, a primary particle of the metal oxide precursor comprise an octahedral-like structure and/or a spherical-like structure.

In some embodiments, a particle size of the primary particles is 50 nm to 500 nm.

In some embodiments, a general chemical formula of the metal oxide precursor is MnₐM₁₋ₐO₂, in which, 0.1 ≤ a ≤ 0.9, and M is at least one selected from Ni, Fe, Cu, and Zn.

In a second aspect, the present application provides a preparation method for the above-mentioned metal oxide precursor. The preparation method is selected from spray pyrolysis.

In some embodiments, a pyrolysis temperature of the spray pyrolysis is 600°C to 900°C.

In some embodiments, an atomization pressure of the spray pyrolysis is 0.4 MPa to 0.6 MPa.

In some embodiments, an air-fuel ratio of the spray pyrolysis is 15 to 20.

In a third aspect, the present application provides a cathode material, which is made from the metal oxide precursor prepared by the above method or the above metal oxide precursor.

In a fourth aspect, the present application provides a cathode plate, including: a cathode current collector, and a cathode material layer disposed on A surface of the cathode current collector. The cathode material layer includes the above-mentioned cathode material.

In a fifth aspect, the present application provides a secondary battery, including the above-mentioned cathode plate.

In the metal oxide precursor of the present application, on the one hand, due to the cumulative particle size distribution curve function of the metal oxide precursor f(x₁) = 25%, f(x₂) = 75%, the average value K' of the tangent slopes of corresponding point values of x₁, x₂, and the n particle size values between x₁ and x₂ in the cumulative particle size distribution curve satisfies that K' > 25, the metal oxide precursor not only has a narrow normal particle size distribution, but also has a high uniformity of particle size distribution, and is easier to embed alkali metal ions when sintering into cathode materials, thus having high sintering activity and excellent sintering uniformity, and allowing the cathode material to have relatively high discharge capacity. On the other hand, since the metal oxide precursor does not have problems such as grain boundaries, and has a higher compression resistance, the structure stability of the cathode material made by the metal oxide precursor can be made stronger, and is not easy to break during the compaction process, thus being conducive to improving the cycle performance.

### BRIEF DESCRIPTION OF THE DRAWINGS

In order to more clearly illustrate the technical solutions in the embodiment of the present application, the drawings required for use in the embodiments or exemplary technical description will be briefly introduced below. Obviously, the drawings described below are only some embodiments of the present application. For ordinary technicians in this field, other drawings can also be obtained based on these drawings without creative work.
FIG. 1 is a graph showing a cumulative particle size distribution curve of a metal oxide precursor in some embodiments of the present application;
FIG. 2 is a scanning electron microscope image of a metal oxide precursor obtained in Example 1 of the present application;
FIG. 3 is a graph showing a particle size distribution curve of the metal oxide precursor obtained in Example 1 of the present application, in which, A is the volume particle size distribution curve and B is a cumulative particle size distribution curve;
FIG. 4 is a scanning electron microscope image of the cathode material obtained in Example 1 of the present application;
FIG. 5 is a scanning electron microscope image of a metal oxide precursor obtained in Comparative Example 1 of the present application;
FIG. 6 is a graph showing a particle size distribution curve of a metal oxide precursor obtained in Comparative Example 1 of the present application, in which, A is the volume particle size distribution curve and B is a cumulative particle size distribution curve;
FIG. 7 is a scanning electron microscope image of a cathode material obtained in Comparative Example 1 of the present application;
FIG. 8 is a scanning electron microscope image of a metal oxide precursor obtained in Comparative Example 3 of the present application;
FIG. 9 is a graph showing a particle size distribution curve of a metal oxide precursor obtained in Comparative Example 3 of the present application, in which, A is the volume particle size distribution curve and B is a cumulative particle size distribution curve;
FIG. 10 is a scanning electron microscope image of a cathode material obtained in comparative example 3 of the present application;
FIG. 11 is a charge and discharge performance test graph of the cathode materials obtained in Example 1 of the present application and Comparative Examples 1-3, in which, A is the charge and discharge performance curve of the cathode material obtained in Example 1, B is the charge and discharge performance curve of the cathode material obtained in Comparative Example 1, C is the charge and discharge performance curve of the cathode material obtained in Comparative Example 1, and D is the charge and discharge performance curve of the cathode material obtained in Comparative Example 1; and

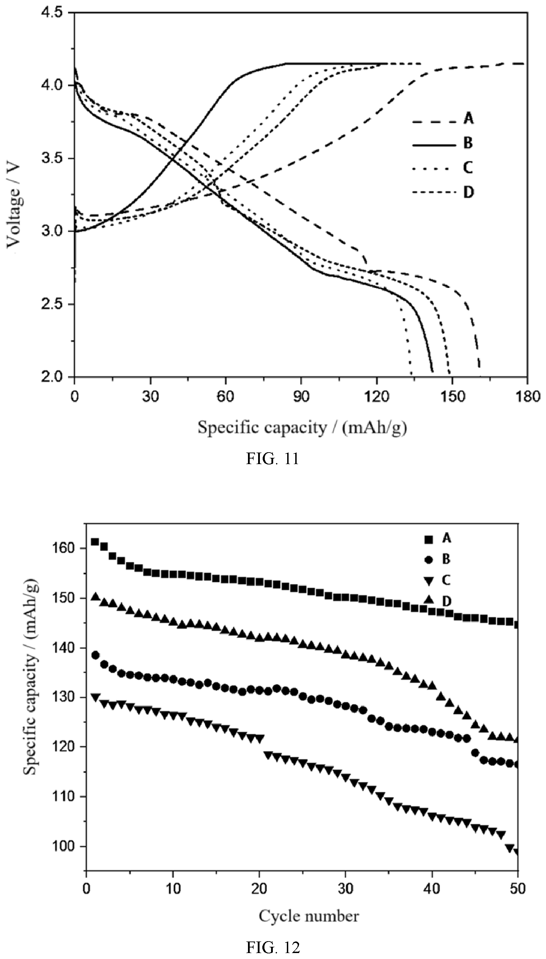

FIG. 12 is a cycle performance test graph of the cathode materials obtained in Example 1 of the present application and Comparative Examples 1-3, in which, A is the specific capacity change of the cathode material obtained in Example 1 at different cycle numbers, B is the specific capacity change of the cathode material obtained in Comparative Example 1 at different cycle numbers, C is the specific capacity change of the cathode material obtained in Comparative Example 1 at different cycle numbers, and D is the specific capacity change of the cathode material obtained in Comparative Example 1 at different cycle numbers.

### DETAILED DESCRIPTION OF THE EMBODIMENTS

In order to clarify the objectives, technical solutions, and advantages of the present application, the present application is further described in detail below in combination with the drawings and embodiments. It should be understood that the specific embodiments described herein are only used to explain the present invention and are not intended to limit the present application.

It should be noted that when a component is referred to as being "fixed to" or "arranged on" another component, it can be directly on the other component or indirectly on the other component. When a component is referred to as being "connected to" another component, it can be directly or indirectly connected to the other component. The orientation or position relationship indicated by the terms "upper", "lower", "left", "right", etc. is based on the orientation or position relationship shown in the drawings, and is only for the convenience of description, and does not indicate or imply that the device or element referred to must have a specific orientation, be constructed and operated in a specific orientation. Therefore, it cannot be understood as a limitation of the present application. For ordinary technicians in this field, the specific meanings of the above terms can be understood according to specific circumstances. The terms "first" and "second" are only used for the purpose of convenience of description, and cannot be understood as indicating or implying relative importance or implicitly indicating the number of technical features. "Multiple" means two or more, unless otherwise clearly and specifically defined.

Unless otherwise defined, all technical and scientific terms used herein have the same meaning as those generally understood by technicians in the technical field of the embodiments of the present application. The terms used in the specification of the embodiments of the present application are only for the purpose of describing specific implementation methods or embodiments, and are not intended to limit the embodiments of the present application. The optional range of the term "and/or" used in this article includes any one of two or more related listed items, and also includes any and all combinations of related listed items, and any and all combinations include any two related listed items, any more related listed items, or all related listed items.

In order to illustrate the technical solution of the present application, the following is a detailed description in conjunction with specific drawings and embodiments.

Some embodiments of the present application provide a metal oxide precursor. The metal oxide precursor is a single-crystal structure, and in a cumulative particle size distribution curve function f(x) of the metal oxide precursor, f(x) is a cumulative particle size distribution, 0 < f(x) < 100%, x is a particle size, 0.05 µm < x < 20 µm;

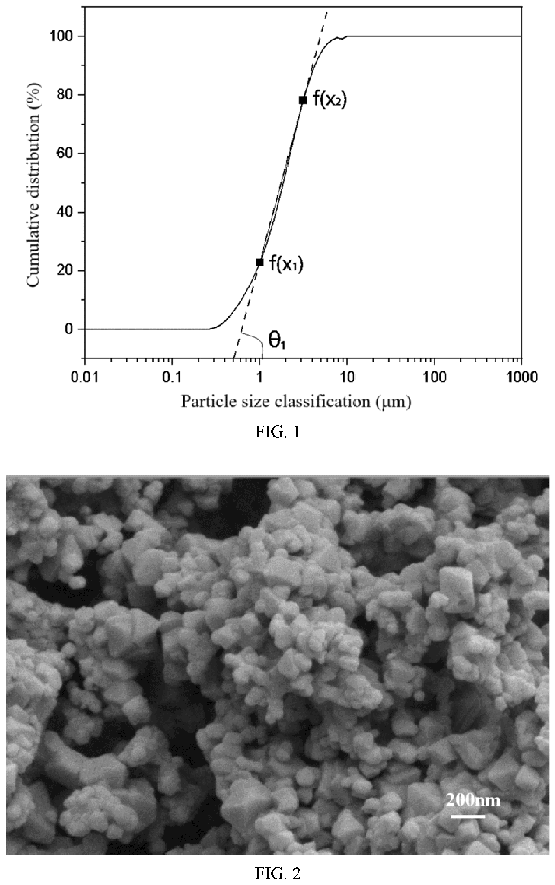

In conjunction with the cumulative particle size distribution curve of the metal oxide precursor in an embodiment shown in FIG. 1, taking FIG. 1 as an example, the X-axis in the cumulative particle size distribution curve function f(x) represents the particle size, but due to the large range of particle size distribution, directly using the original particle size as the X-axis will make the curve too concentrated, so a logarithmic scale (log₁₀) is used as the X-axis. If the particle size is d, the particle size is expressed as log₁₀(d) on the logarithmic scale; the Y-axis represents the corresponding cumulative volume share under the particle size of the X-axis, marked as f(x). In conventional linear coordinates, the X-axis particle size values are too far apart, while in logarithmic coordinates, the distances between these points are equidistantly distributed on the logarithmic coordinates, which reduces the difference within a large numerical range and enables better observation of details within different orders of magnitude. As can be seen from FIG. 1, the larger the X-axis log₁₀(d) is (i.e., the larger the particle size x is), the cumulative volume share f(x) tends to first increase and then stabilize. This is because: in the embodiment of the present application, the cumulative volume distribution reflects the total share of all particles from the smallest size to the current size; when the particle size is small, the cumulative distribution grows slowly because the smaller particles account for a smaller proportion of the total volume; when the particle size increases, the presence of larger particles will increase the cumulative volume distribution. Especially in the "middle section" of the particle distribution, there are a large number of these particles, so the cumulative volume distribution grows faster. After reaching a particle size value, the growth slows down because the volume proportion of large-size particles is already high in such condition, and the proportion of these large-size particles in the material no longer increases significantly, resulting in a slow growth.

When f(x₁)=25%, f(x₂)=75%, there are n particle size values between x₁ and x₂, where n > 0. A tangent slope of each of corresponding point values of x₁, x₂, and the n particle size values in the cumulative particle size distribution curve is K, K is a derivative of the cumulative particle size distribution curve function f(x) of the metal oxide precursor. Thant is, tangent slopes of corresponding point values of x₁ and x₂ in the cumulative particle size distribution curve are K₁ and K₂, respectively; and tangent slopes of corresponding point values of n particle size values in the cumulative particle size distribution curve are Kₙ, respectively. K₁, K₂, and Kₙ are derivatives of cumulative particle size distribution curve functions f(x₁), f(x₂), and f(xₙ) of the metal oxide precursor having particle sizes of x₁, xₙ, and x₂, respectively. Therefore, the average value $K ′ = \frac{{K}_{1} + {K}_{2} + \sum {K}_{n}}{n + 2}$ , where n is the number of particle size values between x₁ and x₂, and a particle size xₙ is a particle size value between the particle size x₁ and the particle size x₂.

In the metal oxide precursor of the present application, on the one hand, due to the cumulative particle size distribution curve function of the metal oxide precursor f(x₁) = 25%, f(x₂) = 75%, the average value K' of the tangent slopes of corresponding point values of x₁, x₂, and the n particle size values between x₁ and x₂ in the cumulative particle size distribution curve satisfies that K' > 25, the metal oxide precursor not only has a narrow normal particle size distribution, but also has a high uniformity of particle size distribution, and is easier to embed alkali metal ions when sintering into cathode materials, thus having high sintering activity and excellent sintering uniformity, and allowing the cathode material to have relatively high discharge capacity. The cumulative particle size distribution curve function of the embodiments of the present application is f(x₁) = 25% to f(x₂) = 75%, that is, corresponding to an interval of particle size from D₂₅ to D₇₅, including particles with a median particle size of D₅₀ in the sample, excluding the influence of extreme particle values like abnormally large or abnormally small particle values, and f(x) is within the interval of between 25% and 75%, which reflects both the central trend and the dispersion degree of the distribution, and is very representative.

On the other hand, the metal oxide precursor that meets the above conditions is a single-crystal particle, the grain orientation is consistent, there is no grain boundary inside, there are fewer defects during the growth process, and it is not easy to produce cracks and micro defects when under pressure, thereby improving the overall strength and compression resistance of the material. It is avoided the issue where different grain orientations in polycrystalline materials can lead to inconsistent responses in the direction of force, causing stress concentration at grain boundaries and resulting in fracture. Since the metal oxide precursor of the embodiments of the present application does not have problems such as grain boundaries, and has a higher compression resistance, the structure stability of the cathode material made by the metal oxide precursor can be made stronger, and is not easy to break during the compaction process, thus being conducive to improving the cycle performance. In addition, the metal oxide precursor also has good structural inheritance, and is easy to prepare a cathode material with a single-crystal structure.

Exemplarily, the value of x may be 0.05 µm, 1 µm, 2 µm, 3 µm, 5 µm, 8 µm, 10 µm, 12 µm, 15 µm, 18 µm, 20 µm, and other typical but non-limiting arbitrary point values or interval values between any two point values.

In some embodiments, in conjunction with FIG. 1, an angle between a straight line having a slope of K' and an X-axis is θ₁, and87.7° ≤ θ₁ ≤ 90°. K' and θ₁ are positively correlated, and the larger the value θ₁, the steeper the straight line having the slope of K', that is, the larger the K', the higher the uniformity of the particle size distribution of the metal oxide precursor. Exemplarily, the angle between the straight line having the slope of K' and the X-axis is θ₁, which may be 87.7°, 88°, 88.5°, 89°, 89.5°, 90°, and other typical but non-limiting arbitrary point values or interval values between any two point values.

In some embodiments, an angle between a straight line having a slope of K' and a Y-axis is θ₂, and θ₂/90° < 0.024. Since θ₁+θ₂=90°, then θ₂/90°=(90°-θ₁)/90°. Herein, (90°-θ₁)/90° represents the particle uniformity µ of the metal oxide precursor, that is, µ < 0.024. When the value µ is closer to 0, the particle size of the metal oxide precursor is more uniform. Exemplarily, the angle between the straight line having the slope of K' and the Y-axis is θ₂, and θ₂/90° may be 0.023 µm, 0.022 µm, 0.02 µm, 0.018 µm, 0.015 µm, 0.012 µm, 0.01 µm, 0.005 µm, and other typical but non-limiting arbitrary point values or interval values between any two point values.

In some embodiments, a D₅₀ of the metal oxide precursor is 0.5 µm to 2.5 µm; and exemplary values may be 0.5 µm, 1 µm, 1.5 µm, 2 µm, 2.5 µm, and other typical but non-limiting arbitrary point values or interval values between any two point values. D₅₀ is also called the median particle diameter.

In some embodiments, a Dₘᵢₙ of the metal oxide precursor is 0.05 µm to 0.3 µm; and exemplary values may be 0.05 µm, 0.1 µm, 0.15 µm, 0.2 µm, 0.25 µm, 0.3 µm, and other typical but non-limiting arbitrary point values or interval values between any two point values. Dₘᵢₙ represents the minimum particle diameter in a particle population.

In some embodiments, a Dₘₐₓ of the metal oxide precursor is 5 µm to 20 µm; and exemplary values may be 5 µm, 8 µm, 10 µm, 12 µm, 15 µm, 18 µm, 20 µm, and other typical but non-limiting arbitrary point values or interval values between any two point values. Dₘₐₓ represents the maximum particle diameter in the particle population.

In some embodiments, a specific surface area of the metal oxide precursor is 8 m²/g-15 m²/g; exemplary values may be 8 m²/g, 9 m²/g, 10 m²/g, 11 m²/g, 12 m²/g, 13 m²/g, 14 m²/g, 15 m²/g, and other typical but non-limiting arbitrary point values or interval values between any two point values.

In the above embodiments of the present application, the D₅₀, the Dₘᵢₙ, the Dₘₐₓ, and the specific surface area are defined, so that the metal oxide precursor has a smaller particle size and a higher specific surface area while satisfying a specific narrow normal particle size distribution and a high particle size distribution uniformity, which is conductive to improving the sintering activity and significantly shortening the preparation time, thereby reducing the energy consumption in preparing the cathode material.

In some embodiments, the primary particles of the metal oxide precursor include an octahedral-like structure and/or a spherical-like structure. In some embodiments, the particle size of the primary particles is 50 nm to 500 nm, and exemplary values may be 50 nm, 100 nm, 200 nm, 300 nm, 400 nm, 500 nm, and other typical but non-limiting arbitrary point values or interval values between any two point values. Compared with the traditional fully developed spinel structure, the metal oxide precursor of the present application requires less energy consumption and lower production cost for the preparation of cathode materials, and small particles with high distribution uniformity are easier to embed sodium ions during sintering, which is beneficial to improve sintering activity.

In some embodiments, a general chemical formula of the metal oxide precursor is MnₐM₁₋ₐO₂, in which, 0.1 ≤ a ≤ 0.9, and M is at least one selected from Ni, Fe, Cu, and Zn. It is understood that the metal oxide precursor of the present application can be a binary metal oxide, a ternary metal oxide, or a quaternary metal oxide, which is not limited in the present application. Exemplarily, parameter a can be any typical but non-limiting point value or an interval value between any two point values such as 0.1, 0.2, 0.3, 0.4, 0.5, 0.6, 0.7, 0.8, 0.9, etc.

The present application provides a preparation method for the above metal oxide precursor, and the preparation method is selected from spray pyrolysis.

It should be noted that the specific operation of the spray pyrolysis can refer to the existing method, and the present application will not repeat it.

In some embodiments, a pyrolysis temperature of the spray pyrolysis is 600°C to 900°C; exemplary values may be 600°C, 700°C, 800°C, 900°C, and other typical but non-limiting arbitrary point values or interval values between any two point values.

In some embodiments, an atomization pressure of the spray pyrolysis is 0.4 MPa to 0.6 MPa; exemplary values may be 0.4 MPa, 0.5 MPa, 0.6 MPa, and other typical but non-limiting arbitrary point values or interval values between any two point values.

In some embodiments, an air-fuel ratio of the spray pyrolysis is 15 to 20, and exemplary values may be 15, 16, 17, 18, 19, 20, and other typical but non-limiting arbitrary point values or interval values between any two point values. The air-fuel ratio is the mass ratio between air and fuel in the mixed gas.

By adjusting the spray pyrolysis temperature, atomization pressure, and air-fuel ratio, it is beneficial to improve the particle size distribution effect of the obtained metal oxide precursor, so that the metal oxide precursor has the characteristics of single-crystal structure, excellent particle size distribution uniformity, and good structural inheritance.

The present application also provides a cathode material made from the above metal oxide precursor.

The metal oxide precursor of the present application is used to prepare the cathode material, which makes it easier to obtain a single-crystal cathode material with good uniformity, thereby facilitating the improvement of the discharge capacity and cycle performance of the cathode material.

It should be noted that the preparation method of the cathode material refers to the existing method, and this application will not repeat it.

This application also provides a cathode plate and a secondary battery including the cathode material, which can be a sodium ion battery. The cathode material includes a cathode current collector and a cathode material layer arranged on a surface of the cathode current collector, and the cathode material layer includes the above cathode material.

In some embodiments, the cathode current collector may be a metal foil or a composite current collector, for example, aluminum foil is used as the metal foil. The composite current collector may be formed by forming a metal material on a polymer material substrate. The metal material includes but is not limited to at least one of aluminum, aluminum alloy, nickel, nickel alloy, titanium, titanium alloy, silver, and silver alloy, and the polymer material substrate includes but is not limited to at least one of polypropylene (PP), polyethylene terephthalate (PET), polybutylene terephthalate (PBT), polystyrene (PS), and polyethylene (PE).

It can be understood that the cathode material layer also includes a binder and a conductive agent. The binder can be any commercially available binder for cathode plates, including but not limited to at least one of polyvinylidene fluoride (PVDF), polytetrafluoroethylene (PTFE), vinylidene fluoride-tetrafluoroethylene-propylene terpolymer, vinylidene fluoride-fluoropropylene-tetrafluoroethylene terpolymer, tetrafluoroethylene-hexafluoropropylene copolymer, fluorine-containing acrylate resins, or a binder prepared by any prior art, which is not limited in the present application. The conductive agent can be any commercially available conductive agent for sodium ion batteries, such as carbon black, graphite, etc.

Hereinafter, the metal oxide precursor, the preparation method therefor, and the use thereof will be described by the following specific examples. However, those skilled in the art will understand that the following examples are only used to illustrate the embodiments of the present application and should not be regarded as limiting the scope of the embodiments of the present application. If the specific conditions are not specified in the embodiments, they are carried out according to conventional conditions or conditions recommended by the manufacturer. If the manufacturer of the reagents or instruments used is not specified, they are all conventional products that can be obtained commercially.

### Example 1

A nickel salt, an iron salt, and a manganese salt were prepared into a mixed metal salt solution according to a metal atomic molar ratio of 4:4:2, and then the mixed metal salt solution was introduced into a roasting furnace in the form of droplets under an atomization pressure of 0.4 MPa. An air-fuel ratio in the roasting furnace was controlled to be 15. Under a pyrolysis temperature of 600°C, the droplets were evaporated, dried, thermally decomposed, and sintered to form a metal oxide precursor. The obtained metal oxide precursor product is simply denoted as NFM442.

A surface morphology of the metal oxide precursor prepared in this example is shown in FIG. 2, and it can be seen that the metal oxide precursor is a single-crystal structure, and its morphology is octahedral-like structures together with some small spherical structures. It is found from testing that the metal oxide precursor has a Dₘᵢₙ of about 0.07 µm, a D₅₀ of about 0.54 µm, a Dₘₐₓ of about 6.7 µm, a specific surface area of about 13.7 m²/g, and a particle size of the primary particles of about 50 nm to 300 nm.

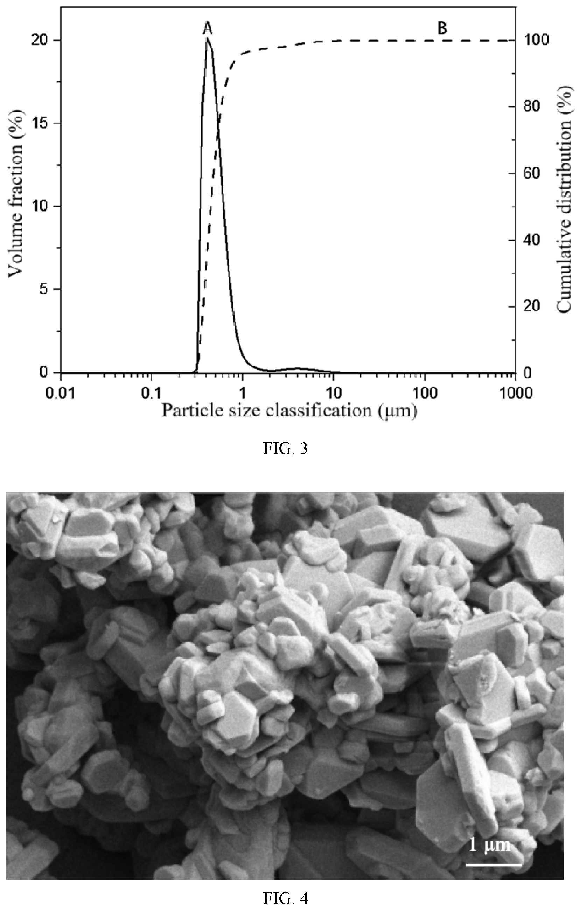

The volume particle size distribution curve and cumulative particle size distribution curve of the metal oxide precursor prepared in this example are shown in FIG. 3. It can be seen that the metal oxide precursor has an extremely narrow particle size distribution, and the slope of the cumulative distribution curve is very steep, indicating that the product particle size is uniform. It is known from calculation that the K' of the metal oxide precursor is 26.1, θ₁ is 87.8°, and µ is 0.024, indicating that the particle size distribution of the metal oxide precursor is very uniform.

The metal oxide precursor prepared in this example was mixed with sodium carbonate in a molar ratio of 1:1, and then placed in a muffle furnace, heated to 900°C at a heating rate of 5°C/min in an air atmosphere, sintered at a constant temperature for 15 hrs, and then naturally cooled, crushed, and sieved to obtain a cathode material with a chemical formula of Na(Ni_{0.4}Fe_{0.4}Mn_{0.2})O₂. A surface morphology of the cathode material prepared in this example is shown in FIG. 4, and it can be seen that the cathode material is a hexagonal prism structure having a uniform size and a smooth surface, indicating that there is no residual alkali on the surface.

### Example 2

A nickel salt, a copper salt, an iron salt, and a manganese salt were prepared into a mixed metal salt solution according to a metal atomic molar ratio of 24:5:36:35, and then the mixed metal salt solution was introduced into a roasting furnace in the form of droplets under an atomization pressure of 0.5 MPa. An air-fuel ratio in the roasting furnace was controlled to be 18. Under a pyrolysis temperature of 800°C, the droplets were evaporated, dried, thermally decomposed, and sintered to form a metal oxide precursor. The obtained metal oxide precursor product is simply denoted as NCFM24/5/36/35.

It is known from testing that the metal oxide precursor has a Dₘᵢₙ of about 0.2 µm, a D₅₀ of about 1.53 µm, a Dₘₐₓ of about 17.4 µm, a specific surface area of about 9.48 m²/g, and a primary particle size of about 60 nm to 400 nm.

It is known from calculation that the K' of the metal oxide precursor is 30, θ₁ is 88.1°, and µ is 0.021, indicating that the particle size distribution of the metal oxide precursor is very uniform.

The metal oxide precursor prepared in this example was mixed with sodium carbonate in a molar ratio of 1:1, and then placed in a muffle furnace. In an air atmosphere, the temperature was increased to 900°C at a heating rate of 5°C/min. After constant temperature sintering for 15 hrs, the cathode material was naturally cooled, crushed, and sieved to obtain a cathode material with a general chemical formula of Na(Ni_{0.24}Cu_{0.05}Fe_{0.36}Mn_{0.35})O₂.

### Example 3

A copper salt, an iron salt, and a manganese salt were prepared into a mixed metal salt solution according to a metal atomic molar ratio of 2:3:5, and then the mixed metal salt solution was introduced into a roasting furnace in the form of droplets under an atomization pressure of 0.6 MPa. An air-fuel ratio in the roasting furnace was controlled to be 20. Under a pyrolysis temperature of 900°C, the droplets were evaporated, dried, thermally decomposed, and sintered to form a metal oxide precursor. The obtained metal oxide precursor product is simply denoted as CFM235.

It is known from testing that the metal oxide precursor has a Dₘᵢₙ of about 0.27 µm, a D₅₀ of about 2.39 µm, a Dₘₐₓ of about 19.6 µm, a specific surface area of about 8.9 m²/g, and a primary particle size of about 65 nm to 450 nm.

It is known from calculation that the K' of the metal oxide precursor is 52, θ₁ is 88.9°, and µ is 0.012, indicating that the particle size distribution of the metal oxide precursor is very uniform.

The metal oxide precursor prepared in this example was mixed with sodium carbonate in a molar ratio of 1:1, and then placed in a muffle furnace. In an air atmosphere, the temperature was increased to 900°C at a heating rate of 5°C/min. After constant temperature sintering for 15 hrs, the mixture was naturally cooled, crushed and sieved to obtain a cathode material with a general chemical formula of Na(Cu_{0.2}Fe_{0.3}Mn_{0.5})O₂.

### Comparative Example 1

A nickel salt, an iron salt, and a manganese salt were prepared into a mixed metal salt solution according to a metal atomic molar ratio of 4:4:2, and then the mixed metal salt solution was introduced into a roasting furnace in the form of droplets under an atomization pressure of 0.7 MPa. An air-fuel ratio in the roasting furnace was controlled to be 23. Under a pyrolysis temperature of 950°C, the droplets were evaporated, dried, thermally decomposed, and sintered to form a metal oxide precursor. The obtained metal oxide precursor product is simply denoted as NFM442.

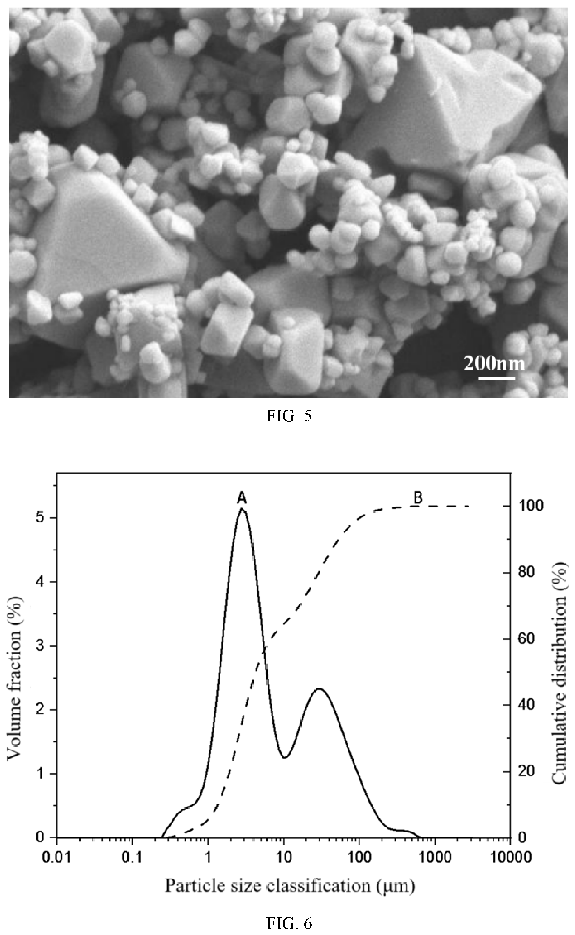

A surface morphology of the metal oxide precursor prepared in this comparative example is shown in FIG. 5. It can be seen that the metal oxide precursor is still a single-crystal structure, and its morphology is an octahedral-like structure, but the particle size is very uneven. It is found from testing that the metal oxide precursor has a Dₘᵢₙ of about 0.32 µm, a D₅₀ of about 5.1 µm, a Dₘₐₓ of about 30.58 µm, a specific surface area of about 5.32 m²/g, and a particle size of the primary particles of about 600 nm to 1200 nm.

The volume particle size distribution curve and cumulative particle size distribution curve of the metal oxide precursor prepared in this comparative example are shown in FIG. 6. It can be seen that the volume particle size distribution curve of the metal oxide precursor is bimodal, the particle size distribution curve is very wide, and the cumulative distribution curve has a small slope, and the particle size uniformity is poor. It is known from calculation that the K' of the metal oxide precursor is 13.7, θ₁ is 85.8°, and µ is 0.046.

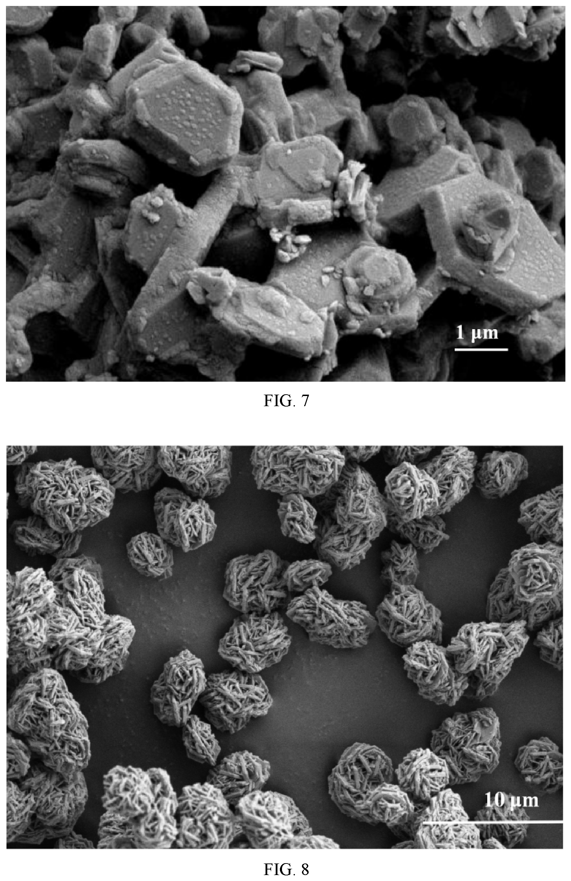

The metal oxide precursor prepared in this comparative example was mixed with sodium carbonate in a molar ratio of 1:1, and then placed in a muffle furnace, heated to 900°C at a heating rate of 5°C/min in an air atmosphere, sintered at a constant temperature for 15 hrs, and then naturally cooled, crushed, and sieved to obtain a cathode material with a chemical formula of Na(Ni_{0.4}Fe_{0.4}Mn_{0.2})O₂. A surface morphology of the cathode material prepared in this comparative example is shown in FIG. 7, and it can be seen that the morphology of the cathode material is a hexagonal prism structure, and the particle surface is rough with a large amount of surface residual alkali, which will make the surface of the cathode material unstable and have an adverse effect on the cyclability and safety of the battery.

### Comparative Example 2

A nickel salt, an iron salt, and a manganese salt were prepared into a mixed metal salt solution according to a metal atomic molar ratio of 4:4:2, and then the mixed metal salt solution was introduced into a roasting furnace in the form of droplets under an atomization pressure of 0.3 MPa. An air-fuel ratio in the roasting furnace was controlled to be 13. Under a pyrolysis temperature of 550°C, the droplets were evaporated, dried, thermally decomposed, and sintered to form a metal oxide precursor. The obtained metal oxide precursor product is simply denoted as NFM442.

It is known from testing that the metal oxide precursor still has a single-crystal structure, but the particles are smaller and incompletely developed. Some of them are octahedral-like structures, and some amorphous small particles have serious agglomeration and are very uneven in size. The metal oxide precursor has a Dₘᵢₙ of about 0.03 µm, a D₅₀ of about 0.49 µm, a Dₘₐₓ of about 4.65 µm, a specific surface area of about 18.93 m²/g, and a particle size of the primary particles of about 20 nm to 200 nm.

It is known from calculation that the K' of the metal oxide precursor is 12, θ₁ is 85.2°, and µ is 0.053.

The metal oxide precursor prepared in this comparative example was mixed with sodium carbonate in a molar ratio of 1:1, and then placed in a muffle furnace, heated to 900°C at a heating rate of 5°C/min in an air atmosphere, sintered at a constant temperature for 15 hrs, and then naturally cooled, crushed, and sieved to obtain a cathode material with a chemical formula of Na(Ni_{0.4}Fe_{0.4}Mn_{0.2})O₂.

### Comparative Example 3

A nickel salt, an iron salt, and a manganese salt were prepared into a metal salt solution with a total molar concentration of 2 mol/L according to the metal atomic molar ratio of 4:4:2, and then a sodium hydroxide solution and an ammonia solution were added into the reactor as a precipitant and a complexing agent, respectively, and nitrogen was introduced as a protective gas. The temperature was kept constant at 55°C, a pH value is controlled at 11, a stirring rate was controlled at 500 r/min, a coprecipitation reaction was carried out for 15 hrs, and then the metal hydroxide precursor was obtained by centrifugal washing and drying.

A surface morphology of the metal hydroxide precursor prepared in this comparative example is shown in FIG. 8, which shows that the metal hydroxide precursor is a polycrystalline structure, and the secondary particles formed by the agglomeration of primary particles are spherical in structure, and the particle size is very uneven. It is found from testing that the metal hydroxide precursor has a Dₘᵢₙ of about 0.51 µm, a D₅₀ of about 5.3 µm, a Dₘₐₓ of about 11.94 µm, and a specific surface area of about 6.5 m²/g.

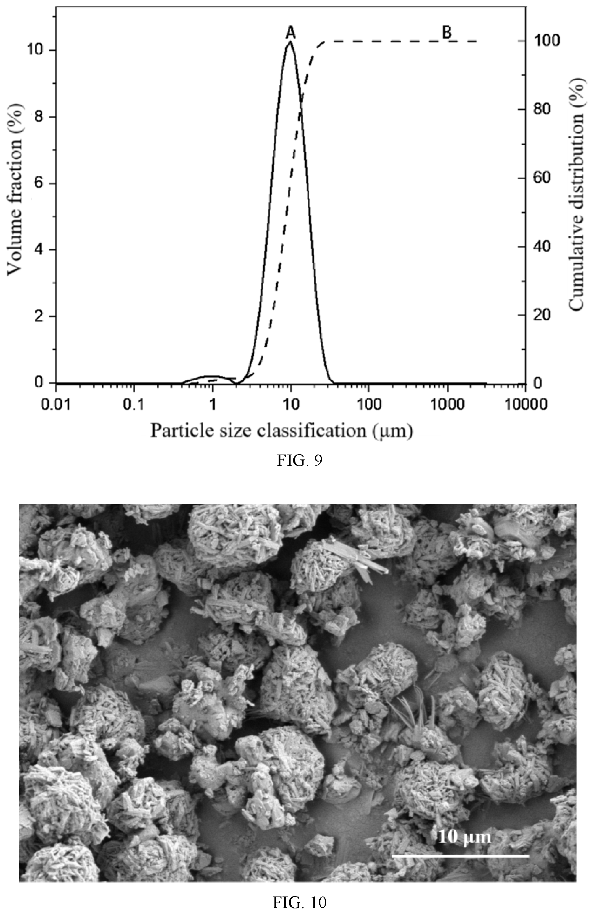

A volume particle size distribution curve and a cumulative particle size distribution curve of the metal hydroxide precursor prepared in this comparative example are shown in FIG. 9. It is known from calculation that the K' of the metal hydroxide precursor is 16.4, θ₁ is 86.5°, and µ is 0.038.

The metal oxide precursor prepared in this comparative example was mixed with sodium carbonate in a molar ratio of 1:1, and then placed in a muffle furnace, heated to 900°C at a heating rate of 5°C/min in an air atmosphere, sintered at a constant temperature for 15 hrs, and then naturally cooled, crushed, and sieved to obtain a cathode material with a chemical formula of Na(Ni_{0.4}Fe_{0.4}Mn_{0.2})O₂. A surface morphology of the cathode material prepared in this comparative example is shown in FIG. 10.

The cathode materials prepared in Examples 1-3 and Comparative Examples 1-3 were made into sodium ion button batteries, and the first discharge specific capacity under a voltage of 2 V to 4.15 V was tested, and the capacity retention rate after 50 cycles was tested. The test results are shown in FIGS. 11-12 and Table 1.

**Table 1**

| | First discharge specific capacity (mAh/g) | After 50 cycles Capacity retention rate (%) |
|---|---|---|
| Example 1 | 161.4 | 91.2 |
| Example 2 | 165.1 | 93.5 |
| Example 3 | 172.3 | 95.6 |
| Comparative Example 1 | 137.9 | 84.5 |
| Comparative Example 2 | 130.2 | 76.3 |
| Comparative Example 3 | 142.1 | 85.3 |

According to FIGS. 11-12 and Table 1, the cathode materials prepared in Examples 1-3 have a high first discharge capacity under the voltage condition of 2 V and 4.15 V, reaching a maximum of about 172.3 mAh/g, and a capacity retention rate after 50 cycles can be maintained at more than 90%, reaching a maximum of about 95.6%. Compared with Example 1, the first discharge capacity and the capacity retention rate after 50 cycles of Comparative Examples 1-3 are significantly reduced.

The technical features of the above embodiments can be combined arbitrarily. To make the description concise, not all possible combinations of the technical features in the above embodiments are described. However, as long as there is no contradiction in the combination of these technical features, they should be considered to be within the scope of this specification.

The above are only optional embodiments of the present application and are not intended to limit the present application. For those skilled in the art, the present application may have various modifications and changes. Any modifications, equivalent substitutions, improvements, etc. made within the spirit and principles of the present application should be included in the scope of the claims of the present application.

## Claims

1. A metal oxide precursor for preparing a cathode material, wherein the metal oxide precursor is a single-crystal structure, and in a cumulative particle size distribution curve function f(x) of the metal oxide precursor, f(x) is a cumulative particle size distribution, 0 < f(x) < 100%, x is a particle size, 0.05 µm < x < 20 µm;
when f(x₁)=25%, f(x₂)=75%, n particle size values exist between x₁ and x₂, in which, n is a number of particle size values between x₁ and x₂, and n > 0; an average value of tangent slopes of corresponding point values of x₁, x₂, and the n particle size values in the cumulative particle size distribution curve is K', K' > 25, wherein a tangent slope of a point value is K, and K is a derivative of the cumulative particle size distribution curve function f(x) of the metal oxide precursor.

2. The metal oxide precursor according to claim 1, wherein in the cumulative particle size distribution curve of the metal oxide precursor, an X-axis is a logarithmic scale of a particle size x of the metal oxide precursor, marked as log₁₀(x), and a Y-axis is a cumulative volume proportion of the metal oxide precursor corresponding to a particle size condition of the X-axis, marked as f(x).

3. The metal oxide precursor according to claim 1, wherein the average value K' of the tangent slopes of corresponding point values of x₁, x₂, and the n particle size values in the cumulative particle size distribution curve is calculated as follows: $K ′ = \frac{{K}_{1} + {K}_{2} + \sum {K}_{n}}{n + 2}$, in which, K₁, K₂, and Kₙ are derivatives of cumulative particle size distribution curve functions f(x₁), f(x₂), and f(xₙ) of the metal oxide precursor having particle sizes of x₁, xₙ, and x₂, respectively, and a particle size xₙ is a particle size value between the particle size x₁ and the particle size x₂.

4. The metal oxide precursor according to claim 1, wherein an angle between a straight line having a slope of K' and an X-axis is θ₁, and 87.7° ≤ θ₁ ≤ 90°.

5. The metal oxide precursor according to claim 1, wherein an angle between a straight line having a slope of K' and a Y-axis is θ₂, and θ₂/90° < 0.024.

6. The metal oxide precursor according to claim 1, wherein a D₅₀ of the metal oxide precursor is 0.5 µm to 2.5 µm.

7. The metal oxide precursor according to claim 1, wherein a Dₘᵢₙ of the metal oxide precursor is 0.05 µm to 0.3 µm.

8. The metal oxide precursor according to claim 1, wherein a Dₘₐₓ of the metal oxide precursor is 5 µm to 20 µm.

9. The metal oxide precursor according to claim 1, wherein a specific surface area of the metal oxide precursor is 8 m²/g to15 m²/g.

10. The metal oxide precursor according to claim 1, wherein a primary particle of the metal oxide precursor comprise an octahedral-like structure and/or a spherical-like structure.

11. The metal oxide precursor according to claim 10, wherein a particle size of the primary particles is 50 nm to 500 nm.

12. The metal oxide precursor according to claim 1, wherein a general chemical formula of the metal oxide precursor is MnₐM₁₋ₐO₂, wherein 0.1 ≤ a ≤ 0.9, and M is at least one selected from Ni, Fe, Cu, and Zn.

13. A preparation method for a metal oxide precursor according to any one of claims 1-12, wherein the preparation method is selected from spray pyrolysis.

14. The preparation method for the metal oxide precursor according to claim 13, wherein a pyrolysis temperature of the spray pyrolysis is 600°C to 900°C.

15. The preparation method for the metal oxide precursor according to claim 13, wherein an atomization pressure of the spray pyrolysis is 0.4 MPa to 0.6 MPa.

16. The preparation method for the metal oxide precursor according to claim 13, wherein an air-fuel ratio of the spray pyrolysis is 15 to 20.

17. A cathode material, wherein the cathode material is made from the metal oxide precursor prepared by the preparation method according to any one of claims 1-12 or the metal oxide precursor according to any one of claims 13-16.

18. A cathode plate, comprising: a cathode current collector, and a cathode material layer arranged on a surface of the cathode current collector, wherein the cathode material layer comprises the cathode material according to claim 17.

19. A secondary battery, comprising the cathode plate according to claim 18.
